(19) Europäisches Patentamt
European Patent Office
Office européen des brevets

(11) EP 0 540 965 B1

(12) **EUROPÄISCHE PATENTSCHRIFT**

(45) Veröffentlichungstag und Bekanntmachung des Hinweises auf die Patenterteilung:
**09.06.1999 Patentblatt 1999/23**

(51) Int Cl.[6]: **G03F 7/004**

(21) Anmeldenummer: **92118250.7**

(22) Anmeldetag: **24.10.1992**

# (54) Positiv arbeitendes strahlungsempfindliches Gemisch und Verfahren zur Herstellung von Reliefmustern

Positive light sensitive composition and process for the formation of relief pattern

Composition à réserve positive sensible aux radiations et procédé de formation de motifs en relief

(84) Benannte Vertragsstaaten:
**BE DE FR IT NL**

(30) Priorität: **02.11.1991 DE 4136213**

(43) Veröffentlichungstag der Anmeldung:
**12.05.1993 Patentblatt 1993/19**

(73) Patentinhaber: **BASF Aktiengesellschaft**
**67063 Ludwigshafen (DE)**

(72) Erfinder:
- **Binder, Horst**
  **W-6840 Lampertheim (DE)**
- **Schwalm, Reinhold, Dr.**
  **W-6707 Wachenheim (DE)**
- **Funhoff, Dirk, Dr.**
  **W-6900 Heidelberg (DE)**

(56) Entgegenhaltungen:
**EP-A- 0 388 813** **EP-A- 0 440 376**
**EP-A- 0 508 174**

- **MICROELECTRONIC ENGINEERING. Bd. 14, Nr. 3/4, September 1991, AMSTERDAM NL Seiten 227 - 236 SCHLEGEL ET AL 'Highly sensitive positive deep-UV resist utilizing a sulfonate acid generator and a tetrahydropyranyl inhibitor'**
- **MICROELECTRONIC ENGINEERING. Bd. 14, Nr. 3/4, September 1991, AMSTERDAM NL Seiten 215 - 226 REICHMANIS E., THOMPSON L.F. 'Chemistry and process for deep-UV resists'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

## Beschreibung für folgende Vertragsstaaten : NL, BE

Die Erfindung betrifft positiv arbeitende strahlungsempfindliche Gemische, die säurelabile Gruppierungen und photoaktive Komponenten enthalten, sensitiv gegenüber UV-Strahlen sind und einen verbesserten Verarbeitungsspielraum aufweisen. Diese strahlungsempfindlichen Gemische eignen sich besonders als Resistmaterialien für Einlagenresiste zur Herstellung von Reliefmustern.

Positiv arbeitende strahlungsempfindliche Gemische sind bekannt. Positiv arbeitende Resistmaterialien, die o-Chinondiazide in wäßrig alkalischen Bindemitteln, z.B. Novolake enthalten, werden kommerziell als Photoresiste eingesetzt, so daß auch die Verfahren zur Herstellung von Reliefbildern bekannt sind.

Neben den o-Chinondiaziden, welche bei Belichtung über die Wolff-Umlagerung eine alkalilösliche Carbonsäure zur Löslichkeitsdifferenzierung ergeben, sind auch alkaliunlösliche organische Carbonsäureester (Benzoesäureester, Phthalsäureester) und Sulfonsäureester (Benzolsulfonsäureester, p-Toluolsulfonsäureester und Naphthalinsulfonsäureester) beschrieben, wobei letztere jedoch nur unter dem Einfluß hochenergetischer Strahlung (Elektronen-, Röntgen- und γ-Strahlen) eine Carbon- bzw. Sulfonsäure zu bilden vermögen, welche die Löslichkeitsdifferenzierung von belichteten und unbelichteten Bereichen bewirkt (vgl. z.B. J 58114 030 A). Die Empfindlichkeit dieser Systeme gegenüber Strahlung ist jedoch teilweise unbefriedigend.

Sulfonsäureester als säurebildende Komponente in UV-strahlungsempfindlichen Gemischen sind noch nicht bekannt.

Man hat auch strahlungsempfindliche Systeme entwickelt, welche in der Primärphotoreaktion eine Spezies erzeugen, die dann unabhängig von der Strahlung eine katalytische Sekundärreaktion auslösen und dadurch die Empfindlichkeiten drastisch erhöhen. Solche Systeme, die photochemisch eine starke Säure erzeugen, die dann in einer Sekundärreaktion säurelabile Gruppen spalten, sind z.B. aus US-PS 3 923 514, US-PS 3 915 706 und DE-A 34 06 927 bekannt.

Als solche photochemisch säureerzeugenden Verbindungen sind beispielsweise Oniumsalze, Halogenverbindungen, Nitrobenzylsulfonate, aktivierte Sulfonsäureester wie Benzointosylate (EP-A-330 406), Alkylsulfonsäurephenylester (EP-A-388 813), Sulfone und Disulfone, Dimethoxyanthracen-2-sulfonsäure-p-nitrobenzylester, Iminosulfonate und Naphthochinon-4-sulfonate bekannt. Einen guten Überblick über photochemische Säurespender geben E. Reichmanis et. al. in Chem. Mater., 3, 394-407 (1991).

In einer Publikation über die Dimethoxyanthracen-sulfonsäure-p-nitrobenzylester (Journal of Photopolymer Science and Technology, Vol. 3, 275-280 (1990)) wird beschrieben, daß zwar die höherkondensierten aromatischen Sulfonsäure-p-nitrobenzylester, z.B. von Anthracen, Pyren etc., bei Belichtung zu den entsprechenden Sulfonsäuren dissoziieren, jedoch nicht die Toluol- bzw. Benzolsulfonsäure-p-nitrobenzylester. Verwendet man anstelle der p-Nitrobenzylester die Ethylester, dissozieren selbst die Ester von höherkondensierten Aromaten nicht zu den entsprechenden Sulfonsäuren bei Bestrahlung mit Licht der Wellenlängen 436 nm, 365 nm und 254 nm.

o-Nitrobenzylsulfonate als Säurespender werden z.B. in EP-A-330 386 beschrieben. Diese Verbindungen reagieren photoinduziert entsprechend der bekannten o-Nitrobenzylumlagerung zu Sulfonsäuren.

Resistsysteme basierend auf t-Butoxycarbonylgruppen als säurelabile Einheiten und entweder z.B. Oniumsalzen oder o-Nitrobenzylester als photochemischen Säurespendern haben allerdings den Nachteil, daß sie sehr empfindlich auf geringste basische Verunreinigungen der Umgebungsluft reagieren und damit einen sehr eingeschränkten Verarbeitungsspielraum aufweisen, wie auf der SPIE Konferenz 4/5. März 1991, Symposium on Microlithography, San Jose, CA, USA, Publikation [1466-01] "Airborne chemical contamination of a chemically amplified resist" und [1466-02] "Preliminary lithographic characteristics of an all-organic chemically amplified resist formulation for single layer deep-UV lithography" geschildert. Beiden Publikationen ist ein eingeengter Verarbeitungsspielraum zu entnehmen; im letzteren zeigt die Lagerung bis zu 15 Minuten nach der Belichtung schon nicht mehr verwendbare Resistprofile.

Weiterhin werden in der DE-A 3 721 741 strahlungsempfindliche Gemische vorgeschlagen, die ein in wäßrigalkalischen Lösungen lösliches polymeres Bindemittel enthalten sowie eine organische Verbindung, deren Löslichkeit in einem wäßrig alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt. Auch diese Gemische zeigen einen eingeschränkten Verarbeitungsspielraum, insbesondere wenn die Umgebungsluft Verunreinigungen, z.B. Basen, enthält.

Der Nachteil vieler dieser Systeme ist also deren Empfindlichkeit gegenüber Lagerzeiten, insbesondere zwischen dem Verfahrensschritt Belichtung und dem darauf folgendem Prozeß der Sekundärreaktion zur Abspaltung der säurelabilen Gruppen, die meist durch Ausheizen unterstützt wird. Lagerzeiten zwischen den Prozeßschritten "Belichtung" und "Ausheizen nach der Belichtung" führen im allgemeinen zu verlängerten Entwicklungszeiten bzw. nichtentwickelbaren Restschichten. Es besteht daher ein Bedarf nach UV-Photoresistsystemen mit hoher Lichtempfindlichkeit, guter Ätzresistenz, Metallionenfreiheit und ausreichendem Verarbeitungsspielraum.

Aufgabe der vorliegenden Erfindung ist es, UV-strahlungsempfindliche Gemische aufzuzeigen, mit denen man rein organische Einlagenphotoresiste auf Basis säurekatalytischer Reaktionen, insbesondere im kurzwelligen UV lichtempfindlicher positiv arbeitender Beschichtungsmaterialien, enthaltend säurelabile organische Gruppierungen und organische photochemische Säurespender, zu Reliefmustern verarbeiten kann, wobei ein praxisgerechter Verarbeitungsspielraum, insbesondere in Bezug auf Lagerzeiten zwischen Belichtung und Ausheizschritten, ermöglicht wird.
Diese Aufgabe läßt sich überraschenderweise sehr vorteilhaft durch die erfindungsgemäßen Gemische lösen.
Gegenstand der vorliegenden Erfindung sind positiv arbeitende UV-strahlungsempfindliche Gemische, enthaltend

(a1) ein säurelabile Ether-, Ester- oder Carbonatgruppen enthaltendes, in Wasser unlösliches organisches Bindemittel, das durch Einwirkung von Säure in wäßrig-alkalischen Lösungen löslich wird, oder

(a2) ein in Wasser unlösliches, in wäßrig-alkalischen Lösungen lösliches polymeres Bindemittel und

(a2.1) eine organische Verbindung, deren Löslichkeit in einem wäßrig-alkalischen Entwickler durch Einwirkung von Säure erhöht wird, oder

(a2.2) eine organische Verbindung, deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine Säure bildet, enthält oder ein Gemisch der organischen Verbindungen (a2.1) und (a2.2) und

(b) eine organische Verbindung, welche unter Einwirkung von UV-Strahlung eine Säure erzeugt,

die dadurch gekennzeichnet sind, daß als organische Verbindung (b) Arylsulfonsäureester der allgemeinen Formel (I)

$$Ar\text{-}SO_2\text{-}O\text{-}R \qquad (I),$$

worin

Ar für Phenyl, ein-, zwei- oder dreifach $C_1$- bis $C_4$-alkyl-, -alkoxi- oder halogen-substituiertes Phenyl oder Nitrophenyl,

R für $C_1$- bis $C_{12}$-Alkyl, Cycloalkyl, Aryl oder Aralkyl mit bis zu 12 Kohlenstoffatomen oder durch Alkyl, Alkoxy oder Halogen ein- oder mehrfach substituiertes Alkyl, Cycloalkyl, Aryl oder Aralkyl mit bis zu 12 Kohlenstoffatomen stehen oder Ar mit R zusammen einen, gegebenenfalls substituierten, fünf- oder sechsgliedrigen Ring bildet, eingesetzt werden.

Als säurelabile Ether-, Ester- oder Carbonatgruppen bevorzugt sind tert.-Butylether von Phenolen, tert.-Alkylcarbonate von Phenolen oder tert.-Butylester von Carbonsäuren.
Als säurelabile Carbonatgruppen enthaltendes organisches Bindemittel (a1) bevorzugt sind insbesondere Poly-p-tert.-butoxycarbonyloxystyrol oder ein Copolymerisat des p-tert.-Butoxycarbonyloxystyrols, als säurelabile Estergruppen enthaltendes organisches Bindemittel (a1) Poly-(tert.-butylmethacrylat) oder ein Copolymerisat des tert.-Butylmethacrylats.
Bevorzugte Beispiele für in Wasser unlösliche, in wäßrig-alkalischen Lösungen lösliche polymere Bindemittel (a2) sind Poly-(p-hydroxystyrol), Poly-(p-hydroxy-α-methylstyrol), Copolymere von p-Hydroxy-(α-methyl)styrol mit t-Butoxycarbonyloxystyrol, t-Amylcarbonyloxystyrol, t-Butoxystyrol, t-Butylmethacrylat, 2-Methylhydroxystyrol und/oder 2,6-Dimethylhydroxystyrol, wobei der Anteil der Comonomeren so gewählt wird, daß die Bindemittel in einem wäßrig-alkalischen Lösungsmittel geeigneten pH-Wertes löslich sind.
Gegenstand der vorliegenden Erfindung ist auch ein Verfahren zur Herstellung von Reliefmustern durch bildmäßige UV-Bestrahlung einer strahlungsempfindlichen Aufzeichnungsschicht in solcher Dosis, daß die Löslichkeit der belichteten Bereiche, gegebenenfalls nach einem thermischen Ausheizschritt bei Temperaturen zwischen 60 und 130°C, in wäßrig-alkalischen Lösungen zunimmt und diese Bereiche selektiv mit dem wäßrig-alkalisch Entwickler entfernt werden können, wobei die strahlungsempfindliche Aufzeichnungsschicht im wesentlichen aus einem erfindungsgemäßen strahlungsempfindlichen Gemisch besteht.
Die erfindungsgemäßen strahlungsempfindlichen Gemische ermöglichen überraschenderweise die Herstellung von Reliefmustern und Reliefbildern mit hoher Auflösung bei praxisgerechter Verarbeitbarkeit mit genügend großem Verarbeitungsspielraum, insbesondere mit tolerierbaren Lagerzeiten zwischen Belichtung und Ausheizschritt > 15 Minuten.

Weiterhin ist die Empfindlichkeit der Systeme durch die katalytische Wirkung der photochemisch erzeugten Säuren sehr hoch, und es ergeben sich sehr hohe Kontrastwerte. Diese strahlungsempfindlichen Gemische sind daher für die Anwendung in der Deep-UV Lithographie sehr gut geeignet.

Zu den Aufbaukomponenten des erfindungsgemäßen strahlungsempfindlichen Gemisches ist im einzelnen folgendes auszuführen.

(a1) Als säurelabile Ether-, Ester- oder Carbonatgruppen enthaltende, in Wasser unlösliche organische Bindemittel (a1), die durch Einwirkung von Säure in wäßrig-alkalischen Lösungen löslich werden, kommen Polymere auf Basis von Homo- oder Copolymeren des p-t-Butoxystyrols, p-t-Butoxycarbonyloxystyrols oder t-Amylcarbonyloxystyrols, als Comonomereinheiten kommen dabei alle mit Styrol copolymerisierbaren Monomeren, beispielsweise Acrylate, Methacrylate, Styrol und dessen Derivate, Schwefeldioxid, Maleinimide, insbesondere jedoch p-Hydroxistyrol und/oder p-Hydroxy-α-methylstyrol und in o-Stellung zur OH-Gruppe mono- oder disubstituierte Hydroxistyrole in Betracht; bevorzugt sind Poly-(p-t-butoxycarbonyloxy)styrol und Poly-(p-t-butoxystyrol). Das polymere Bindemittel (a1) ist im erfindungsgemäßen Gemisch im allgemeinen in einer Menge von 55 bis 99, vorzugsweise 70 bis 97 Gew.-%, bezogen auf die Summe der Komponenten (a1) und (b) enthalten.

(a2) Als in Wasser unlösliche, in wäßrig-alkalischen Lösungen lösliche polymere Bindemittel (a2) kommen Polymere auf Basis von Homo- oder Copolymeren des p-Hydroxistyrols und/oder p-Hydroxi-α-methylstyrols in Betracht, wobei als Comonomereinheiten besonders in o-Stellung zur Hydroxygruppe mono- oder disubstituierte Hydroxistyrole oder Hydroxistyrole, deren phenolische Gruppe mit säurelabilen Gruppierungen geschützt ist, in Frage kommen. Besonders bevorzugte säurelabile Gruppierungen sind dabei t-Alkylcarbonate, wie t-Butylcarbonate, t-Amylcarbonate, Ether und Acetale, wie t-Butylether sowie t-Butylester. Die Comonomereinheiten sind dabei nur in solchen Mengen vorhanden, daß das Polymere wäßrig alkalisch löslich ist, bevorzugt im Bereich von 10 bis 70 Mol%.

Die Polymeren (a1) bzw. (a2) weisen im allgemeinen mittlere Molekulargewichte $\overline{M}w$ zwischen 2 000 und 100 000, vorzugsweise zwischen 8 000 und 30 000 auf.

Als organische Verbindungen (a2.1), welche säurelabile Gruppen, bevorzugt t-Alkylether, t-Alkylester, Acetale oder t-Alkylcarbonate enthalten, seien hier beispielhaft aufgeführt:

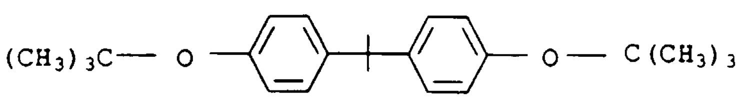

,

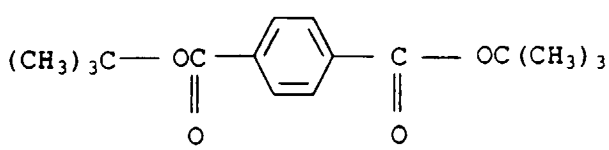

,

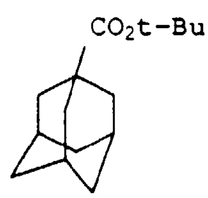

,

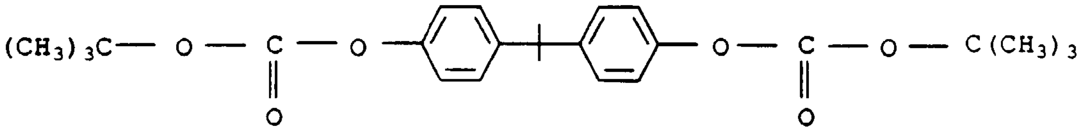 ,

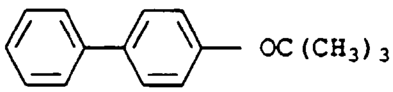 , 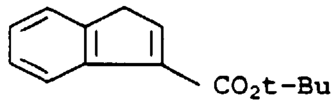

und

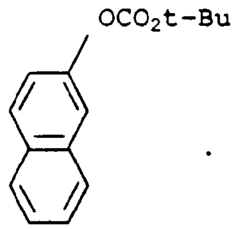 .

Als organische Verbindungen (a2.2), deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure enthält, kommen insbesondere Oniumsalze, enthaltend säurelabile Gruppierungen, wie sie in US-A 4 883 740 beschrieben sind, in Frage.

Besonders bevorzugte organische Verbindungen (a 2.1) sind solche der allgemeinen Formel (II)

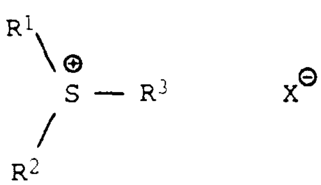 (II)

worin $R^1$, $R^2$ und $R^3$ untereinander gleich oder verschieden sind und für aliphatische und/oder aromatische Reste, die gegebenenfalls Heteroatome enthalten, stehen oder zwei der Reste $R^1$ bis $R^3$ miteinander zu einem Ring verknüpft sind, mit der Maßgabe, daß mindestens einer der Reste $R^1$ bis $R^3$ mindestens eine durch Säure spaltbare Gruppierung, vorzugsweise t-Butylcarbonate von Phenolen bzw. t-Alkyl-ether von Phenolen enthält, wobei einer der Reste $R^1$ bis $R^3$ mit einem oder mehreren weiteren Sulfoniumsalzresten, gegebenenfalls über durch Säure spaltbare Gruppierungen, verknpft sein kann und $X^{\ominus}$ ein nichtnucleophiles Gegenion bedeutet.

Als Gegenion kommen bevorzugt starke organische Säureanionen wie Tosylat, Mesylat, Benzolsulfonat, Trifluormethansulfonat und Fluorsulfonat, in Frage.

b) Als organische Verbindungen (b) kommen erfindungsgemäß Arylsulfonsäureester der allgemeinen Formel (I)

$$Ar\text{-}SO_2\text{-}O\text{-}R \qquad (I),$$

in Frage, worin Ar für Phenyl, ein-, zwei- oder dreifach $C_1$- bis $C_4$-alkylsubstituiertes Phenyl, beispielsweise Tolyl, Xylyl, ein-, zwei- oder dreifach $C_1$- bis $C_4$-alkoxysubstituiertes Phenyl, beispielsweise Methoxyphenyl, Ethoxyphenyl, Propoxyphenyl, Butoxyphenyl, halogensubstituiertes Phenyl, wie z.B. Chlorphenyl oder Bromphenyl oder Nitrophenyl,

R für $C_1$- bis $C_{12}$-, vorzugsweise $C_1$- bis $C_6$-Alkyl, beispielsweise Methyl, Ethyl, n-Propyl, Isopropyl, n-Butyl, Isobutyl, tert.-Butyl, Amyl, Hexyl, Octyl, 2-Ethylhexyl, Decyl, Dodecyl, Cycloalkyl, wie z.B. Cyclohexyl oder Cyclopentyl, Aryl wie z.B. Phenyl, Aralkyl mit bis zu 12 Kohlenstoffatomen, wie z.B. Benzyl, für durch Alkyl, Alkoxy oder Halogen (wie z.B. Fluor, Chlor, Brom) ein- oder mehrfach substituiertes Alkyl, Cycloalkyl, Aryl oder Aralkyl mit bis zu 12 Kohlenstoffatomen, oder Ar mit R zusammen einen, gegebenenfalls durch Halogen, wie Fluor, Chlor oder Brom oder Alkyl mit 1 bis 2 Kohlenstoffatomen oder Alkoxy mit 1 bis 2 Kohlenstoffatomen substituierten, fünf- oder sechsgliedrigen Ring bildet, z.B.

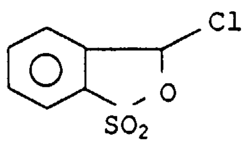

oder

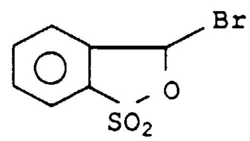

Beispiele für bevorzugte Verbindungen (b) sind

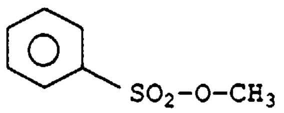

,

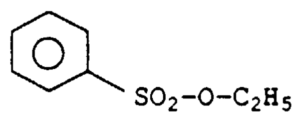

,

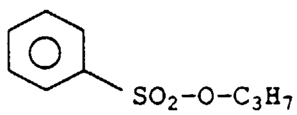

,

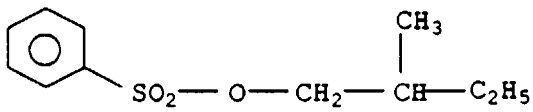

,

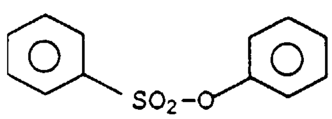

oder

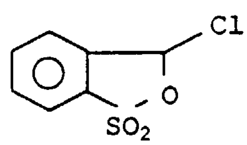

.

Die Verbindungen (b) sind im erfindungsgemäßen Gemisch im allgemeinen in einer Menge von 0,5 bis 20, vorzugsweise 1 bis 15 Gew.-%, bezogen auf die Gesamtmenge des strahlungsempfindlichen Gemisches enthalten.

Die organischen Verbindungen (b) der Formel (I) können alle im Prinzip nach Verfahren hergestellt werden, wie sie in der Literatur bereits beschrieben sind, beispielsweise in Organikum, VEB-Verlag Berlin 1976, 15. Auflage, Seite 684.

Für den Fall von erfindungsgemäßen Gemischen der Komponenten (a2), (a2.1) und (b) ist die Komponente (a2) vorzugsweise in Mengen von 90 - 40 Gew.-%, die Komponente (a2.1) in Mengen von 9 bis 40 Gew.-% und die Komponente (b) in Mengen von 1 bis 20 Gew.-%, bezogen auf die Gesamtmenge der Komponenten (a2) + (a2.1) + (b) enthalten.

Für den Fall von Gemischen der Komponenten (a2), (a2.1) und/oder (a2.2) und (b) sind diese vorzugsweise in Mengen von 97 bis 60 Gew.-% (a2), 1 bis 20 Gew.-% (a2.1), 1 bis 20 Gew.-% (a2.2) und 1 bis 20 Gew.-% (b), bezogen auf die Gesamtmenge dieser Komponenten enthalten, mit der Maßgabe, daß die Summe der Prozentzahlen jeweils gleich 100 ist, und wobei die Komponenten (a2.1) und (a2.2) sich gegenseitig ersetzen können.

Die erfindungsgemäßen Gemische werden zur Herstellung von Resists, für Reliefmuster bevorzugt in einem organischen Lösungsmittel gelöst, wobei der Feststoffgehalt üblicherweise im Bereich zwischen 5 und 40 Gew.-% liegt. Als Lösungsmittel kommen bevorzugt aliphatische Ketone, Ether und Ester, sowie Mischungen derselben

in Frage. Besonders bevorzugt sind Alkylenglykolmonoalkylether, wie beispielsweise Ethyl-cellosolve, Butylglykol, Methyl-cellosolve und 1-Methoxy-2-propanol, Alkylenglykolalkylether-ester, wie beispielsweise Methyl-cellosolve-acetat, Methyl-propylenglykol-acetat, und Ethyl-propylenglykol-acetat und Ketone, wie beispielsweise Cyclohexanon, Cyclopentanon und Methylethylketon, sowie Acetate, wie Butylacetat und Aromaten, wie Toluol und Xylol sowie Ethylacetat und Diacetonalkohol. Die Auswahl der entsprechenden Lösungsmittel, sowie deren Mischungen richtet sich nach der Wahl des jeweiligen Polymers und der photoaktiven Komponente.

Weiterhin können dem erfindungsgemäßen Gemisch andere Zusätze wie Haftvermittler, Netzmittel, Farbstoffe und Weichmacher zugesetzt werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind dafür bevorzugt, jedoch können auch andere Farbstoffe, die als Sensibilisatoren wirken, verwendet werden.

Beim erfindungsgemäßen Verfahren zur Herstellung von Reliefmustern wird in üblicher Weise eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche, gegebenenfalls nach einem thermischen Ausheizschritt bei Temperaturen zwischen 60°C und 130°C, in wäßrig alkalischen Lösungsmitteln zunimmt und diese Bereiche selektiv mit dem alkalischen Entwickler entfernt werden können.

Vorzugsweise werden z.B. das polymere Bindemittel mit säurelabilen Gruppierungen und 1 - 10, insbesondere 2 bis 5 Gew.-% eines erfindungsgemäßen Arylsulfonsäureesters (b), bezogen auf den Feststoffgehalt des strahlungsempfindlichen Gemisches, in Methoxypropylacetat gelöst, wobei der Feststoffgehalt zwischen 10 und 30 Gew.-% liegt. Die Lösung kann durch ein Filter mit der Porenweite von 0,2 µm filtriert werden. Durch Aufschleudern der Resistlösung bei Umdrehungszahlen zwischen 1 000 und 10 000 U/ min wird ein Resistfilm in einer Schichtdicke von 2 bis 0,5 µm auf einem oberflächenoxidierten Siliziumwafer erzeugt. Der Wafer wird dann zur Trocknung zwischen 1 min und 5 min bei Temperaturen zwischen 60 und 120°C ausgeheizt. Die Filme werden dann z.B. durch eine chrombeschichtete strukturierte Quarzmaske mit UV-Licht einer Quecksilber-Hochdrucklampe oder mit Excimer-Laserlicht bildmäßig bestrahlt. Die bestrahlten Filme werden mit wäßrig-alkalischen oder alkoholhaltigen wäßrig-alkalischen Entwicklern entwickelt oder gegebenenfalls vorher zwischen 5 Sekunden und 5 min bei Temperaturen zwischen 60°C und 130°C ausgeheizt.

Das erfindungsgemäße Verfahren zeichnet sich insbesondere dadurch aus, daß man Lagerzeiten in normaler Umgebungsluft größer 15 Minuten zwischen den Verfahrensschritten "Belichtung" und "Ausheizen nach der Belichtung" tolerieren kann ohne an Leistungsfähigkeit, d.h. Sensitivität und Strukturgüte, einzubüßen.

Die in den Beispielen genannten Teile und Prozente sind, soweit nicht anders angegeben Gewichtsteile bzw. Gewichtsprozente.

Beispiel 1

Eine Photoresistlösung wird aus 10 Teilen Ethyl-4-toluolsulfonat, 90 Teilen Poly-(p-vinylphenol-co-p-t-butoxicarbonyloxistyrol) (molares Verhältnis der Comonomeren 8:2) und 300 Teilen Methoxypropylacetat hergestellt. Durch ein Filter mit einem Porendurchmesser von 0,2 µm wird diese Lösung anschließend filtriert.

Von dieser Lösung wird eine ca. 1 µm dicke Schicht auf oberflächlich oxidierte Siliziumwafer aufgeschleudert und 1 min bei 90°C ausgeheizt. Nach der Belichtung durch eine strukturierte Testmaske mit Excimer-Laserlicht der Wellenlänge 248 nm werden diese Wafer bei unterschiedlichen Temperaturen (Hotplatezeit/Hotplatetemperatur) ausgeheizt und mit einem alkalischen Entwickler strukturiert.

Der $\Gamma_p$-Wert wurde aus den Kontrast-Kurven ermittelt. Für Positiv-Resistsysteme ist der Gamma-Wert definiert als $\Gamma_p = [\log\frac{D_1}{D_0}]^{-1}$ , wobei $D_0$ und $D_1$ die extrapolierten Belichtungsenergiedosen aus der Dunkelabtragsenergiekurve darstellen.

| Hotplatezeit [min] | Hotplatetemperatur [°C] | Belichtung (Fotospeed) mJ/cm$^2$ | Kontrast $\Gamma_p$ |
|---|---|---|---|
| 1 min | 90 | Strukturierung nicht möglich | |
| 1 min | 100 | 140 | 2,7 |
| 1 min | 110 | 60 | 5,6 |
| 1 min | 120 | 40 | 8,0 |
| 1 min | 130 | 29 | 32 |

Beispiel 2

Es werden mit der Resistlösung gemäß Beispiel 1 mehrere Wafer belackt, ausgeheizt und belichtet. Nach einer Lagerzeit von 1, 2 und 4 Stunden erfolgt die thermische Nachbehandlung (1 min bei 120°C). Alle Wafer lassen sich einwandfrei zu einem positiven Reliefmuster entwickeln. Es sind keine Unterschiede zwischen den unterschiedlich gelagerten Wafern festellbar.

Vergleichsbeispiel 1

Wird Tris-(4-t-butoxicarbonyloxiphenyl-)sulfoniumtrifluormethansulfonat statt Ethyl-4-toluolsufonat verwendet, können bereits nach einer Stunde Lagerzeit die Wafer nicht mehr strukturiert werden.

Beispiel 3

Eine Photoresistlösung wird analog Beispiel 1 hergestellt, jedoch wird als Sulfonat (-)-Di-O-tosyl-2,3,0-isopropyliden-L-threitol (Fluka) verwendet.
Diese Resistlösung wird auf einen oxidierten Siliziumwafer aufgeschleudert und der Polymerfilm auf der Hotplate 1 min. bei 90°C ausgeheizt.
Nach Belichtung durch eine strukturierte Testmaske wird ein Wafer sofort, ein Kontrollwafer erst nach einer Wartezeit von 2 Stunden ausgeheizt (1 min. bei 120°C) und entwickelt.
Die Entwicklungszeit bei unterschiedlichen Belichtungsenergien der beiden Wafer wurde gemessen. Es lassen sich praktisch keine Unterschiede feststellen:

| Belichtungsenergie mJ/cm$^2$ | Entwicklungszeit (sec.) | |
|---|---|---|
| | Wafer 1 | Kontrollwafer |
| 56 | 21 | 20 |
| 66 | 20 | 20 |
| 76 | 21 | 22 |

Vergleichsbeispiel 2

Es wird eine Resistformulierung aus 6 Teilen Tris-(4-t-butoxicarbonyloxiphenyl-)sulfoniumtrifluormethansulfonat, 94 Teilen Poly-(p-vinylphenol und 300 Teilen Methyl-propylenglycolacetat hergestellt.
Diese Lösung wird analog Beispiel 3 verarbeitet. Nach 2 Stunden Lagerzeit zwischen Belichtung und Ausheizen ist das Resistmuster nicht mehr entwickelbar.

Beispiel 4

Eine Photoresistlösung, bestehend aus 10 Teilen p-Toluolsulfonsäure-2-methylbutylester, 90 Teilen Poly-(p-vinylphenol-co-p-t-butoxicarbonyloxistyrol) (molares Verhältnis der Comonomeren 8:2) und 300 Teilen Methoxypropylacetat wird gemäß Beispiel 1 auf oxidierte Siliziumwafer aufgeschleudert und 1 min bei 90°C ausgeheizt.
Nach der Belichtung mit Excimer-Laserlicht der Wellenlänge 248 nm, dem Temperprozeß und der Strukturierung mit einem alkalischen Entwickler wurden folgende Restschichtdicken mit dem Profilometer gemessen:

| Belichtungsenergie [mJ/cm$^2$] | Restschicht [%] |
|---|---|
| 50 | 1,001 |
| 113 | 1,001 |
| 133 | 0,966 |
| 152 | 0,392 |
| 187 | 0,276 |
| 225 | 0 |

Beispiel 5

Eine Photoresistlösung, bestehend aus 10 Teilen p-Toluolsulfonsäuremethylester, 90 Teilen Poly-(p-vinylphenol-co-t-butoxicarbonyloxistyrol) (molares Verhältnis der Comonomeren 8:2) und 300 Teilen Methoxypropylacetat wird analog Beispiel 4 behandelt, auf oberflächenoxidierte Si-Wafer aufgetragen und getrocknet. Nach der Strukturierung mit einem alkalischen Entwickler wurden folgende Restschichtdicken gemessen:

| Belichtungsenergie [mJ/cm$^2$] | Restschicht [%] |
|---|---|
| 36 | 0,997 |
| 44 | 0,928 |
| 50 | 0,787 |
| 58 | 0,476 |
| 66 | 0,209 |
| 84 | 0 |
| 94 | 0 |

Beispiel 6

Eine Photoresistlösung wird aus 5 Teilen 3-Chlor-1,2-benzoxathial-1,1-dioxid, 95 Teilen Poly-(p-vinylphenol-co-p-t-butoxicarbonyloxistyrol) (molares Verhältnis der Comonomeren 8:2) und 300 Teilen Methoxypropylacetat hergestellt und analog Beispiel 4 behandelt, auf oberflächenoxidierte Si-Wafer aufgeschleudert und getrocknet. Es lassen sich nach der Entwicklung mit einem alkalischen Medium folgende Restschichtdicken ermitteln:

| Belichtungsenergie [mJ/cm$^2$] | Restschicht [%] |
|---|---|
| 18,20 | 1,0 |
| 25,2 | 1,00 |
| 33,25 | 0,99 |
| 41,8 | 0,98 |
| 76,3 | 0,89 |
| 94,0 | 0,0 |
| 113,0 | 0,0 |

Wafer, die nach der Belichtung gelagert werden, lassen sich auch nach einer Stunde noch gut entwickeln.

Beispiel 7

10 Teile (+)-1,4-Di-O-tosyl-2,3,0-isopropyliden-D-threitol und 90 Teile Poly-(p-vinyl-phenol-co-p-t-butoxicarbonyloxistyrol) (molares Verhältnis der Comonomeren 8:2) werden in 300 Teilen Methoxypropylacetat gelöst. Dann wurde analog Beispiel 4 weiterverfahren.

Mit ca. 36 mJ/cm$^2$ lassen sich Strukturen kleiner 1 µm erzeugen. Auch nach Lagerung von 1 Stunde sind die Wafer noch gut entwickelbar.

Beispiel 8

10 Teile p-Toluolsulfonsäure-phenylester, 90 Teile Poly-(p-vinyl-phenol-co-p-t-butoxicarbonyloxistyrol) (molares Verhältnis der Comonomeren 8:2) werden in 300 Teilen Methoxypropylacetat gelöst. Nach der Filtration dieser Lösung, wird eine ca. 1 µm dicke Polymerschicht auf oxidierte Siliziumwafer aufgeschleudert und 1 min bei 90°C auf einer Hotplate ausgeheizt.

Nach der Belichtung durch eine strukturierte Testmaske mit Excimer-Laserlicht der Wellenlänge 248 nm werden die Wafer zur Ermittlung der günstigsten Prozessparameter bei verschiedenen Temperaturen ausgeheizt und anschließend sofort entwickelt. Gute Strukturen waren bei Temperaturen zwischen 110°C und 120°C schon nach 1

min zu erhalten. Werden die Wafer unterhalb 100°C ausgeheizt, wird für die Strukturierung längere Zeit benötigt.
Strukturierte Wafer, die belichtet mehrere Stunden gelagert und anschließend noch 1 min. bei 120°C gelagert wurden, waren gut zu entwikkeln.

**Beschreibung für folgende Vertragsstaaten : DE, FR, IT**

Die Erfindung betrifft positiv arbeitende strahlungsempfindliche Gemische, die säurelabile Gruppierungen und photoaktive Komponenten enthalten, sensitiv gegenüber UV-Strahlen sind und einen verbesserten Verarbeitungsspielraum aufweisen. Diese strahlungsempfindlichen Gemische eignen sich besonders als Resistmaterialien für Einlagenresiste zur Herstellung von Reliefmustern.
Positiv arbeitende strahlungsempfindliche Gemische sind bekannt. Positiv arbeitende Resistmaterialien, die o-Chinondiazide in wäßrig alkalischen Bindemitteln, z.B. Novolake enthalten, werden kommerziell als Photoresiste eingesetzt, so daß auch die Verfahren zur Herstellung von Reliefbildern bekannt sind.
Neben den o-Chinondiaziden, welche bei Belichtung über die Wolff-Umlagerung eine alkalilösliche Carbonsäure zur Löslichkeitsdifferenzierung ergeben, sind auch alkaliunlösliche organische Carbonsäureester (Benzoesäureester, Phthalsäureester) und Sulfonsäureester (Benzolsulfonsäureester, p-Toluolsulfonsäureester und Naphthalinsulfonsäureester) beschrieben, wobei letztere jedoch nur unter dem Einfluß hochenergetischer Strahlung (Elektronen-, Röntgen- und $\gamma$-Strahlen) eine Carbon- bzw. Sulfonsäure zu bilden vermögen, welche die Löslichkeitsdifferenzierung von belichteten und unbelichteten Bereichen bewirkt (vgl. z.B. J 58114 030 A). Die Empfindlichkeit dieser Systeme gegenüber Strahlung ist jedoch teilweise unbefriedigend.
Sulfonsäureester als säurebildende Komponente in UV-strahlungsempfindlichen Gemischen sind noch nicht bekannt.
Man hat auch strahlungsempfindliche Systeme entwickelt, welche in der Primärphotoreaktion eine Spezies erzeugen, die dann unabhängig von der Strahlung eine katalytische Sekundärreaktion auslösen und dadurch die Empfindlichkeiten drastisch erhöhen. Solche Systeme, die photochemisch eine starke Säure erzeugen, die dann in einer Sekundärreaktion säurelabile Gruppen spalten, sind z.B. aus US-PS 3 923 514, US-PS 3 915 706 und DE-A 34 06 927 bekannt.
Als solche photochemisch säureerzeugenden Verbindungen sind beispielsweise Oniumsalze, Halogenverbindungen, Nitrobenzylsulfonate, aktivierte Sulfonsäureester wie Benzointosylate (EP-A-330 406), Alkylsulfonsäurephenylester (EP-A-388 813), Sulfone und Disulfone,
Dimethoxyanthracen-2-sulfonsäure-p-nitrobenzylester, Iminosulfonate und Naphthochinon-4-sulfonate bekannt. Einen guten Überlick über photochemische Säurespender geben E. Reichmanis et. al. in Chem. Mater., 3, 394-407 (1991).
In einer Publikation über die Dimethoxyanthracen-sulfonsäure-p-nitrobenzylester (Journal of Photopolymer Science and Technology, Vol. 3, 275-280 (1990)) wird beschrieben, daß zwar die höherkondensierten aromatischen Sulfonsäure-p-nitrobenzylester, z.B. von Anthracen, Pyren etc., bei Belichtung zu den entsprechenden Sulfonsäuren dissoziieren, jedoch nicht die Toluol- bzw. Benzolsulfonsäure-p-nitrobenzylester. Verwendet man anstelle der p-Nitrobenzylester die Ethylester, dissozieren selbst die Ester von hoherkondensierten Aromaten nicht zu den entsprechenden Sulfonsäuren bei Bestrahlung mit Licht der Wellenlängen 436 nm, 365 nm und 254 nm.
o-Nitrobenzylsulfonate als Säurespender werden z.B. in EP-A-330 386 beschrieben. Diese Verbindungen reagieren photoinduziert entsprechend der bekannten o-Nitrobenzylumlagerung zu Sulfonsäuren.
Resistsysteme basierend auf t-Butoxycarbonylgruppen als säurelabile Einheiten und entweder z.B. Oniumsalzen oder o-Nitrobenzylester als photochemischen Säurespendern haben allerdings den Nachteil, daß sie sehr empfindlich auf geringste basische Verunreinigungen der Umgebungsluft reagieren und damit einen sehr eingeschränkten Verarbeitungsspielraum aufweisen, wie auf der SPIE Konferenz 4/5. März 1991, Symposium on Microlithography, San Jose, CA, USA, Publikation [1466-01] "Airborne chemical contamination of a chemically amplified resist" und [1466-02] "Preliminary lithographic characteristics of an all-organic chemically amplified resist formulation for single layer deep-UV lithography" geschildert. Beiden Publikationen ist ein eingeengter Verarbeitungsspielraum zu entnehmen; im letzteren zeigt die Lagerung bis zu 15 Minuten nach der Belichtung schon nicht mehr verwendbare Resistprofile.
Weiterhin werden in der DE-A 3 721 741 strahlungsempfindliche Gemische vorgeschlagen, die ein in wäßrigalkalischen Lösungen lösliches polymeres Bindemittel enthalten sowie eine organische Verbindung, deren Löslichkeit in eimem wäßrig alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt. Auch diese Gemische zeigen einen eingeschränkten Verarbeitungsspielraum, insbesondere wenn die Umgebungsluft Verunreinigungen, z.B. Basen, enthält.
Der Nachteil vieler dieser Systeme ist also deren Empfindlichkeit gegenüber Lagerzeiten, insbesondere zwischen dem Verfahrensschritt Belichtung und dem darauf folgendem Prozeß der Sekundärreaktion zur Abspaltung der säurelabilen Gruppen, die meist durch Ausheizen unterstützt wird. Lagerzeiten zwischen den Prozeßschritten "Belichtung" und "Ausheizen nach der Belichtung" führen im allgemeinen zu verlängerten Entwicklungszeiten bzw. nichtentwickelbaren Restschichten. Es besteht daher ein Bedarf nach UV-Photoresistsystemen mit hoher Lichtempfindlichkeit, guter Ätzresistenz, Metallionenfreiheit und ausreichendem Verarbeitungsspielraum.

Aufgabe der vorliegenden Erfindung ist es, UV-strahlungsempfindliche Gemische aufzuzeigen, mit denen man rein organische Einlagenphotoresiste auf Basis säurekatalytischer Reaktionen, insbesondere im kurzwelligen UV lichtempfindlicher positiv arbeitender Beschichtungsmaterialien, enthaltend säurelabile organische Gruppierungen und organische photochemische Säurespender, zu Reliefmustern verarbeiten kann, wobei ein praxisgerechter Verarbeitungsspielraum, insbesondere in Bezug auf Lagerzeiten zwischen Belichtung und Ausheizschritten, ermöglicht wird.

Diese Aufgabe läßt sich überraschenderweise sehr vorteilhaft durch die erfindungsgemäßen Gemische lösen.

Gegenstand der vorliegenden Erfindung sind positiv arbeitende UV-strahlungsempfindliche Gemische, enthaltend

(a) ein säurelabile Ether-, Ester- oder Carbonatgruppen enthaltendes, in Wasser unlösliches organisches Bindemittel, das durch Einwirkung von Säure in wäßrig-alkalischen Lösungen löslich wird, und

(b) eine organische Verbindung, welche unter Einwirkung von UV-Strahlung eine Säure erzeugt,

die dadurch gekennzeichnet sind, daß als organische Verbindung (b) Arylsulfonsäureester der allgemeinen Formel (I)

$$Ar\text{-}SO_2\text{-}O\text{-}R \qquad (I),$$

worin

Ar für Phenyl, ein-, zwei- oder dreifach $C_1$- bis $C_4$-alkyl-, -alkoxi- oder halogen-substituiertes Phenyl oder Nitrophenyl,

R für $C_1$- bis $C_{12}$-Alkyl, Cycloalkyl, Aryl oder Aralkyl mit bis zu 12 Kohlenstoffatomen oder durch Alkyl, Alkoxy oder Halogen ein- oder mehrfach substituiertes Alkyl, Cycloalkyl, Aryl oder Aralkyl mit bis zu 12 Kohlenstoffatomen stehen oder Ar mit R zusammen einen, gegebenenfalls substituierten, fünf- oder sechsgliedrigen Ring bildet, eingesetzt werden.

Als säurelabile Ether-, Ester- oder Carbonatgruppen bevorzugt sind tert.-Butylether von Phenolen, tert.-Alkylcarbonate von Phenolen oder tert.-Butylester von Carbonsäuren.

Als säurelabile Carbonatgruppen enthaltendes organisches Bindemittel (a1) bevorzugt sind insbesondere Poly-p-tert.-butoxycarbonyloxystyrol oder ein Copolymerisat des p-tert.-Butoxycarbonyloxystyrols, als säurelabile Estergruppen enthaltendes organisches Bindemittel (a1) Poly-(tert.-butylmethacrylat) oder ein Copolymerisat des tert.-Butylmethacrylats.

Bevorzugte Beispiele für in Wasser unlösliche, in wäßrig-alkalischen Lösungen lösliche polymere Bindemittel (a2) sind Poly-(p-hydroxystyrol), Poly-(p-hydroxy-$\alpha$-methylstyrol), Copolymere von p-Hydroxy-($\alpha$-methyl)styrol mit t-Butoxycarbonyloxystyrol, t-Amylcarbonyloxystyrol, t-Butoxystyrol, t-Butylmethacrylat, 2-Methylhydroxystyrol und/oder 2,6-Dimethylhydroxystyrol, wobei der Anteil der Comonomeren so gewählt wird, daß die Bindemittel in einem wäßrig-alkalischen Lösungsmittel geeigneten pH-Wertes löslich sind.

Gegenstand der vorliegenden Erfindung ist auch ein Verfahren zur Herstellung von Reliefmustern durch bildmäßige UV-Bestrahlung einer strahlungsempfindlichen Aufzeichnungsschicht in solcher Dosis, daß die Löslichkeit der belichteten Bereiche, gegebenenfalls nach einem thermischen Ausheizschritt bei Temperaturen zwischen 60 und 130°C, in wäßrig-alkalischen Lösungen zunimmt und diese Bereiche selektiv mit dem wäßrig-alkalisch Entwickler entfernt werden können, wobei die strahlungsempfindliche Aufzeichnungsschicht im wesentlichen aus einem erfindungsgemäßen strahlungsempfindlichen Gemisch besteht.

Die erfindungsgemäßen strahlungsempfindlichen Gemische ermöglichen überraschenderweise die Herstellung von Reliefmustern und Reliefbildern mit hoher Auflösung bei praxisgerechter Verarbeitbarkeit mit genügend großem Verarbeitungsspielraum, insbesondere mit tolerierbaren Lagerzeiten zwischen Belichtung und Ausheizschritt > 15 Minuten.

Weiterhin ist die Empfindlichkeit der Systeme durch die katalytische Wirkung der photochemisch erzeugten Säuren sehr hoch, und es ergeben sich sehr hohe Kontrastwerte. Diese strahlungsempfindlichen Gemische sind daher für die Anwendung in der Deep-UV Lithographie sehr gut geeignet.

Zu den Aufbaukomponenten des erfindungsgemäßen strahlungsempfindlichen Gemisches ist im einzelnen

folgendes auszuführen.

(a) Als säurelabile Ether-, Ester- oder Carbonatgruppen enthaltende, in Wasser unlösliche organische Bindemittel (a1), die durch Einwirkung von Säure in wäßrig-alkalischen Lösungen löslich werden, kommen Polymere auf Basis von Homo- oder Copolymeren des p-t-Butoxystyrols, p-t-Butoxycarbonyloxystyrols oder t-Amylcarbonyloxystyrols, als Comonomereinheiten kommen dabei alle mit Styrol copolymerisierbaren Monomeren, beispielsweise Acrylate, Methacrylate, Styrol und dessen Derivate, Schwefeldioxid, Maleinimide, insbesondere jedoch p-Hydroxistyrol und/oder p-Hydroxy-α-methylstyrol und in o-Stellung zur OH-Gruppe mono- oder disubstituierte Hydroxistyrole in Betracht; bevorzugt sind Poly-(p-t-butoxycarbonyloxy)styrol und Poly-(p-t-butoxystyrol). Das polymere Bindemittel (a1) ist im erfindungsgemäßen Gemisch im allgemeinen in einer Menge von 55 bis 99, vorzugsweise 70 bis 97 Gew.-%, bezogen auf die Summe der Komponenten (a1) und (b) enthalten.

b) Als organische Verbindungen (b) kommen erfindungsgemäß Arylsulfonsäureester der allgemeinen Formel (I)

$$Ar\text{-}SO_2\text{-}O\text{-}R \qquad (I),$$

in Frage, worin Ar für Phenyl, ein-, zwei- oder dreifach $C_1$- bis $C_4$-alkylsubstituiertes Phenyl, beispielsweise Tolyl, Xylyl, ein-, zwei- oder dreifach $C_1$- bis $C_4$-alkoxysubstituiertes Phenyl, beispielsweise Methoxyphenyl, Ethoxyphenyl, Propoxyphenyl, Butoxyphenyl, halogensubstituiertes Phenyl, wie z.B. Chlorphenyl oder Bromphenyl oder Nitrophenyl,
R für $C_1$- bis $C_{12}$-, vorzugsweise $C_1$- bis $C_6$-Alkyl, beispielsweise Methyl, Ethyl, n-propyl, Isopropyl, n-Butyl, Isobutyl, tert.-Butyl, Amyl, Hexyl, Octyl, 2-ethylhexyl, Decyl, Dodecyl, Cycloalkyl, wie z.B. Cyclohexyl oder Cyclopentyl, Aryl wie z.B. Phenyl, Aralkyl mit bis zu 12 Kohlenstoffatomen, wie z.B. Benzyl, für durch Alkyl, Alkoxy oder Halogen (wie z.B. Fluor, Chlor, Brom) ein- oder mehrfach substituiertes Alkyl, Cycloalkyl, Aryl oder Aralkyl mit bis zu 12 Kohlenstoffatomen, oder Ar mit R zusammen einen, gegebenenfalls durch Halogen, wie Fluor, Chlor oder Brom oder Alkyl mit 1 bis 2 Kohlenstoffatomen oder Alkoxy mit 1 bis 2 Kohlenstoffatomen substituierten, fünf- oder sechsgliedrigen Ring bildet, z.B.

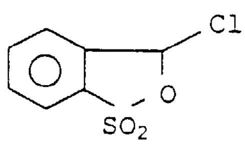 oder 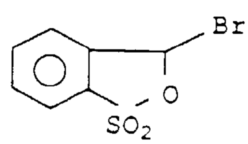

Beispiele für bevorzugte Verbindungen (b) sind

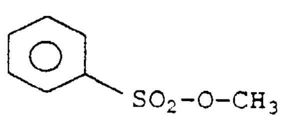 , 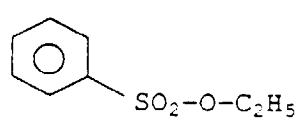 ,

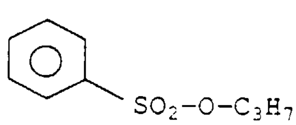 , 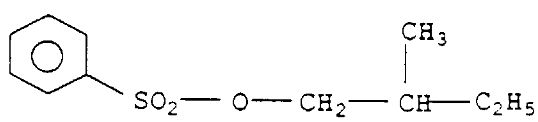 ,

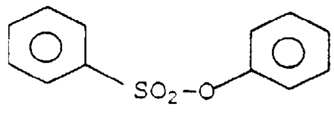 oder 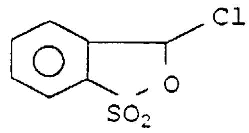 .

Die Verbindungen (b) sind im erfindungsgemäßen Gemisch im allgemeinen in einer Menge von 0,5 bis 20, vorzugsweise 1 bis 15 Gew.-%, bezogen auf die Gesamtmenge des strahlungsempfindlichen Gemisches enthalten.

Die organischen Verbindungen (b) der Formel (I) können alle im Prinzip nach Verfahren hergestellt werden, wie sie in der Literatur bereits beschrieben sind, beispielsweise in Organikum, VEB-Verlag Berlin 1976, 15. Auflage, Seite 684.

Die erfindungsgemäßen Gemische werden zur Herstellung von Resists, für Reliefmuster bevorzugt in einem organischen Lösungsmittel gelöst, wobei der Feststoffgehalt üblicherweise im Bereich zwischen 5 und 40 Gew.-% liegt. Als Lösungsmittel kommen bevorzugt aliphatische Ketone, Ether und Ester, sowie Mischungen derselben in Frage. Besonders bevorzugt sind Alkylenglykolmonoalkylether, wie beispielsweise Ethyl-cellosolve, Butylglykol, Methyl-cellosolve und 1-Methoxy-2-propanol, Alkylenglykolalkylether-ester, wie beispielsweise Methyl-cellosolve-acetat, Methyl-propylenglykol-acetat, und Ethyl-propylenglykol-acetat und Ketone, wie beispielsweise Cyclohexanon, Cyclopentanon und Methylethylketon, sowie Acetate, wie Butylacetat und Aromaten, wie Toluol und Xylol sowie Ethylacetat und Diacetonalkohol. Die Auswahl der entsprechenden Lösungsmittel, sowie deren Mischungen richtet sich nach der Wahl des jeweiligen Polymers und der photoaktiven Komponente.

Weiterhin können dem erfindungsgemäßen Gemisch andere Zusätze wie Haftvermittler, Netzmittel, Farbstoffe und Weichmacher zugesetzt werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind dafür bevorzugt, jedoch können auch andere Farbstoffe, die als Sensibilisatoren wirken, verwendet werden.

Beim erfindungsgemäßen Verfahren zur Herstellung von Reliefmustern wird in üblicher Weise eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche, gegebenenfalls nach einem thermischen Ausheizschritt bei Temperaturen zwischen 60°C und 130°C, in wäßrig alkalischen Lösungsmitteln zunimmt und diese Bereiche selektiv mit dem alkalischen Entwickler entfernt werden können.

Vorzugsweise werden z.B. das polymere Bindemittel mit säurelabilen Gruppierungen und 1 - 10, insbesondere 2 bis 5 Gew.-% eines erfindungsgemäßen Arylsulfonsäureesters (b), bezogen auf den Feststoffgehalt des strahlungsempfindlichen Gemisches, in Methoxypropylacetat gelöst, wobei der Feststoffgehalt zwischen 10 und 30 Gew.-% liegt. Die Lösung kann durch ein Filter mit der Porenweite von 0,2 µm filtriert werden. Durch Aufschleudern der Resistlösung bei Umdrehungszahlen zwischen 1 000 und 10 000 U/ min wird ein Resistfilm in einer Schichtdicke von 2 bis 0,5 µm auf einem oberflächenoxidierten Siliziumwafer erzeugt. Der Wafer wird dann zur Trocknung zwischen 1 min und 5 min bei Temperaturen zwischen 60 und 120°C ausgeheizt. Die Filme werden dann z.B. durch eine chrombeschichtete strukturierte Quarzmaske mit UV-Licht einer Quecksilber-Hochdrucklampe oder mit Excimer-Laserlicht bildmäßig bestrahlt. Die bestrahlten Filme werden mit wäßrig-alkalischen oder alkoholhaltigen wäßrig-alkalischen Entwicklern entwickelt oder gegebenenfalls vorher zwischen 5 Sekunden und 5 min bei Temperaturen zwischen 60°C und 130°C ausgeheizt.

Das erfindungsgemäße Verfahren zeichnet sich insbesondere dadurch aus, daß man Lagerzeiten in normaler Umgebungsluft größer 15 Minuten zwischen den Verfahrensschritten "Belichtung" und "Ausheizen nach der Belichtung" tolerieren kann ohne an Leistungsfähigkeit, d.h. Sensitivität und Strukturgüte, einzubüßen.

Die in den Beispielen genannten Teile und Prozente sind, soweit nicht anders angegeben Gewichtsteile bzw. Gewichtsprozente.

Beispiel 1

Eine Photoresistlösung wird aus 10 Teilen Ethyl-4-toluolsulfonat, 90 Teilen Poly-(p-vinylphenol-cc-p-t-butoxicarbonyloxistyrol) (molares Verhältnis der Comonomeren 8:2) und 300 Teilen Methoxypropylacetat hergestellt. Durch ein Filter mit einem Porendurchmesser von 0,2 µm wird diese Lösung anschließend filtriert.

Von dieser Lösung wird eine ca. 1 µm dicke Schicht auf oberflächlich oxidierte Siliziumwafer aufgeschleudert

und 1 min bei 90°C ausgeheizt. Nach der Belichtung durch eine strukturierte Testmaske mit Excimer-Laserlicht der Wellenlänge 248 nm werden diese Wafer bei unterschiedlichen Temperaturen (Hotplatezeit/Hotplatetemperatur) ausgeheizt und mit einem alkalischen Entwickler strukturiert.

Der $\Gamma_p$-Wert wurde aus den Kontrast-Kurven ermittelt. Für Positiv-Resistsysteme ist der Gamma-Wert definiert als $\Gamma_p = [\log\frac{D_1}{D_0}]^{-1}$, wobei $D_0$ und $D_1$ die extrapolierten Belichtungsenergiedosen aus der Dunkelabtragsenergiekurve darstellen.

| Hotplatezeit [min] | Hotplatetemperatur [°C] | Belichtung (Fotospeed) mJ/cm$^2$ | Kontrast $\Gamma_p$ |
|---|---|---|---|
| 1 min | 90 | Strukturierung nicht möglich | |
| 1 min | 100 | 140 | 2,7 |
| 1 min | 110 | 60 | 5,6 |
| 1 min | 120 | 40 | 8,0 |
| 1 min | 130 | 29 | 32 |

Beispiel 2

Es werden mit der Resistlösung gemäß Beispiel 1 mehrere Wafer belackt, ausgeheizt und belichtet. Nach einer Lagerzeit von 1, 2 und 4 Stunden erfolgt die thermische Nachbehandlung (1 min bei 120°C). Alle Wafer lassen sich einwandfrei zu einem positiven Reliefmuster entwickeln. Es sind keine Unterschiede zwischen den unterschiedlich gelagerten Wafern festellbar.

Vergleichsbeispiel 1

Wird Tris-(4-t-butoxicarbonyloxiphenyl-)sulfoniumtrifluormethansulfonat statt Ethyl-4-toluolsufonat verwendet, können bereits nach einer Stunde Lagerzeit die Wafer nicht mehr strukturiert werden.

Beispiel 3

Eine Photoresistlösung wird analog Beispiel 1 hergestellt, jedoch wird als Sulfonat (-)-Di-O-tosyl-2,3,0-isopropyliden-L-threitol (Fluka) verwendet.

Diese Resistlösung wird auf einen oxidierten Siliziumwafer aufgeschleudert und der Polymerfilm auf der Hotplate 1 min. bei 90°C ausgeheizt.

Nach Belichtung durch eine strukturierte Testmaske wird ein wafer sofort, ein Kontrollwafer erst nach einer Wartezeit von 2 Stunden ausgeheizt (1 min. bei 120°C) und entwickelt.

Die Entwicklungszeit bei unterschiedlichen Belichtungsenergien der beiden Wafer wurde gemessen. Es lassen sich praktisch keine Unterschiede feststellen:

| Belichtungsenergie mJ/cm$^2$ | Entwicklungszeit (sec.) | |
|---|---|---|
| | Wafer 1 | Kontrollwafer |
| 56 | 21 | 20 |
| 66 | 20 | 20 |
| 76 | 21 | 22 |

Vergleichsbeispiel 2

Es wird eine Resistformulierung aus 6 Teilen Tris-(4-t-butoxicarbonyloxiphenyl-)sulfoniumtrifluormethansulfonat, 94 Teilen Poly-(p-vinylphenol und 300 Teilen Methyl-propylenglycolacetat hergestellt.

Diese Lösung wird analog Beispiel 3 verarbeitet. Nach 2 Stunden Lagerzeit zwischen Belichtung und Ausheizen ist das Resistmuster nicht mehr entwickelbar.

Beispiel 4

Eine Photoresistlösung, bestehend aus 10 Teilen p-Toluolsulfonsäure-2-methylbutylester, 90 Teilen Poly-(p-vinylphenol-co-p-t-butoxicarbonyloxistyrol) (molares Verhältnis der Comonomeren 8:2) und 300 Teilen Methoxypropylacetat wird gemäß Beispiel 1 auf oxidierte Siliziumwafer aufgeschleudert und 1 min bei 90°C ausgeheizt.

Nach der Belichtung mit Excimer-Laserlicht der Wellenlänge 248 nm, dem Temperprozeß und der Strukturierung mit einem alkalischen Entwickler wurden folgende Restschichtdicken mit dem Profilometer gemessen:

| Belichtungsenergie [mJ/cm$^2$] | Restschicht [%] |
|---|---|
| 50 | 1,001 |
| 113 | 1,001 |
| 133 | 0,966 |
| 152 | 0,392 |
| 187 | 0,276 |
| 225 | 0 |

Beispiel 5

Eine Photoresistlösung, bestehend aus 10 Teilen p-Toluolsulfonsäuremethylester, 90 Teilen Poly-(p-vinylphenol-co-t-butoxicarbonyloxistyrol) (molares Verhältnis der Comonomeren 8:2) und 300 Teilen Methoxypropylacetat wird analog Beispiel 4 behandelt, auf oberflächenoxidierte Si-Wafer aufgetragen und getrocknet. Nach der Strukturierung mit einem alkalischen Entwickler wurden folgende Restschichtdicken gemessen:

| Belichtungsenergie [mJ/cm$^2$] | Restschicht [%] |
|---|---|
| 36 | 0,997 |
| 44 | 0,928 |
| 50 | 0,787 |
| 58 | 0,476 |
| 66 | 0,209 |
| 84 | 0 |
| 94 | 0 |

Beispiel 6

Eine Photoresistlösung wird aus 5 Teilen 3-Chlor-1,2-benzoxathial-1,1-dioxid, 95 Teilen Poly-(p-vinylphenol-co-p-t-butoxicarbonyloxistyrol) (molares Verhältnis der Comonomeren 8:2) und 300 Teilen Methoxypropylacetat hergestellt und analog Beispiel 4 behandelt, auf oberflächenoxidierte Si-Wafer aufgeschleudert und getrocknet. Es lassen sich nach der Entwicklung mit einem alkalischen Medium folgende Restschichtdicken ermitteln:

| Belichtungsenergie [mJ/cm$^2$] | Restschicht [%] |
|---|---|
| 18,20 | 1,0 |
| 25,2 | 1,00 |
| 33,25 | 0,99 |
| 41,8 | 0,98 |
| 76,3 | 0,89 |
| 94,0 | 0,0 |
| 113,0 | 0,0 |

Wafer, die nach der Belichtung gelagert werden, lassen sich auch nach einer Stunde noch gut entwickeln.

Beispiel 7

10 Teile (+)-1,4-Di-O-tosyl-2,3,0-isopropyliden-D-threitol und 90 Teile Poly-(p-vinyl-phenol-co-p-t-butoxicarbonyloxistyrol) (molares Verhältnis der Comonomeren 8:2) werden in 300 Teilen Methoxypropylacetat gelöst. Dann wurde analog Beispiel 4 weiterverfahren.
Mit ca. 36 $mJ/cm^2$ lassen sich Strukturen kleiner 1 µm erzeugen. Auch nach Lagerung von 1 Stunde sind die Wafer noch gut entwickelbar.

Beispiel 8

10 Teile p-Toluolsulfonsäure-phenylester, 90 Teile Poly-(p-vinyl-phenol-co-p-t-butoxicarbonyloxistyrol) (molares Verhältnis der Comonomeren 8:2) werden in 300 Teilen Methoxypropylacetat gelöst. Nach der Filtration dieser Lösung, wird eine ca. 1 µm dicke Polymerschicht auf oxidierte Siliziumwafer aufgeschleudert und 1 min bei 90°C auf einer Hotplate ausgeheizt.
Nach der Belichtung durch eine strukturierte Testmaske mit Excimer-Laserlicht der Wellenlänge 248 nm werden die Wafer zur Ermittlung der gunstigsten Prozessparameter bei verschiedenen Temperaturen ausgeheizt und anschließend sofort entwickelt. Gute Strukturen waren bei Temperaturen wischen l10°C und 120°C schon nach 1 min zu erhalten. Werden die Wafer unterhalb 100°C ausgeheizt, wird für die Strukturierung längere Zeit benötigt.
Strukturierte Wafer, die belichtet mehrere Stunden gelagert und anschließend noch 1 min. bei 120°C gelagert wurden, waren gut zu entwikkeln.

## Patentansprüche

### Patentansprüche für folgende Vertragsstaaten : NL, BE

**1.** Positiv arbeitendes UV-strahlungsempfindliches Gemisch enthaltend

(a1) eine säurelabile Ether-, Ester- oder Carbonatgruppen enthaltendes, in Wasser unlösliches organisches Bindemittel, das durch Einwirkung von Säure in wäßrig-alkalischen Lösungen löslich wird, oder

(a2) ein in Wasser unlösliches, in wäßrig-alkalischen Lösungen lösliches polymeres Bindemittel und

(a2.1) eine organische Verbindung, deren Löslichkeit in einem wäßrig-alkalischem Entwickler durch Einwirkung von Säure erhöht wird und die mindestens eine durch Säure spaltbare Gruppierung, die unter Einwirkung von Strahlung eine Säure bildet, enthält, oder ein Gemisch der organischen Verbindungen (a2.1 und (a2.2) und

(a2.2) eine organische Verbindung, deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine Säure bildet, enthält oder ein Gemisch der organischen Verbindungen (a2.1) und (a2.2) und

(b) eine organische Verbindung, welche unter Einwirkung von UV-Strahlung eine Säure erzeugt,

dadurch gekennzeichnet, daß es als organische Verbindung (b) enthält Arylsulfonsäureester der allgemeinen Formel (I)

$$Ar - SO_2 - O - R \qquad (I),$$

worin

Ar für Phenyl, ein-, zwei- oder dreifach $C_1$-$C_4$-alkyl-, $C_1$-$C_4$-alkoxy- oder halogen-substituiertes Phenyl oder Nitrophenyl,

R für $C_1$-$C_{12}$-Alkyl, Cycloalkyl, Aryl oder Aralkyl mit bis zu 12 C-Atomen oder durch Alkyl, Alkoxy oder Halogen,

einfach oder mehrfach substituiertes Alkyl, Cycloalkyl, Aryl oder Aralkyl mit bis zu 12 C-Atomen stehen,

oder Aryl mit R zusammen einen, ggf. substituierten, fünf- oder sechsgliedrigen Ring bildet, oder daß es als organische Verbindung (b) Di-O-tosyl-2,3-O-isopropyliden-threitol enthält.

**2.** Strahlungsempfindlichen Gemisch nach Anspruch 1, dadurch gekennzeichnet, daß es als organische Verbindungen (b) eine Verbindung ausgewählt aus der Gruppe von Benzolsulfonsäuremethylester, Benzolsulfonsäureethylester, Benzolsulfonsäurepropylester oder Benzolsulfonsäure-2-methylbutylester enthält.

**3.** Strahlungsempfindliches Gemisch nach Anspruch 1, dadurch gekennzeichnet, daß es als organische Verbindung (b) 3-Halogen-1,2-benzoxathia1-1,1-dioxid enthält, worin Hal für Chlor oder Brom steht.

**4.** Strahlungsempfindliches Gemisch nach Anspruch 1, dadurch gekennzeichnet, daß es als organische Verbindung (b) einen phenylester der Benzol- oder Toluolsulfonsäure enthält.

**5.** Strahlungsempfindliches Gemisch gemäß einem der Ansprüche 1 bis 4, dadurch gekennzeichnet, daß es als säurelabile Ether-, Ester- oder Carbonatgruppen im Bindemittel (a1) tert.Butylether von Phenolen, tert. Alkyl-carbonate von Phenolen oder tert. Butylester von Carbonsäuren enthält.

**6.** Strahlungsempfindliches Gemisch nach einem der Ansprüche 1 bis 5, dadurch gekennzeichnet, daß es als säurelabile Carbonatgruppen enthaltendes organisches Bindemittel (a1) Poly-p-tert.butoxycarbonyloxystyrol oder ein Copolymerisat des p-tert.butoxycarbonyloxystyrols enthält.

**7.** Strahlungsempfindliches Gemisch nach einem der Ansprüche 1 bis 5, dadurch gekennzeichnet, daß es als säurelabile Estergruppen enthaltendes organisches Bindemittel (a1) Poly-tert.butylmethacrylat oder ein Copolymerisat des tert.Butylmethacrylats enthält.

**8.** Strahlungsempfindliches Gemisch nach Anspruch 1, dadurch gekennzeichnet, daß das in Wasser unlösliche, in wäßrig-alkalischen Lösungen lösliche polymere Bindemittel (a2) Poly-p-hydroxystyrol, Poly-p-hydroxy-α-methylstyrol, ein Copolymer von p-Hydroxy-α-methylstyrol mit tert.Butoxy-carbonyloxystyrol tert.Amylcarbonyloxystyrol, tert.Butoxystyrol, tert.Butylmethacrylat, 2-Methylhydroxystyrol und/oder 2,6-Dimethylhydroxystyrol ist.

**9.** Verfahren zur Herstellung von Reliefmustern, wobei eine strahlungsempfindliche Aufzeichnungsschicht bildmässig in solcher Dosis mit UV-Licht bestrahlt wird, daß die Löslichkeit der belichteten Bereiche, gegebenenfalls nach einem thermischen Ausheizungsschritt, bei Temperaturen zwischen 60 und 130°C, in wäßrig-alkalischen Lösungen zunimmt und diese Bereiche selektiv mit dem wäßrig-alkalischen Entwickler entfernt werden können, dadurch gekennzeichnet, daß die strahlungsempfindliche Aufzeichnungsschicht im wesentlichen aus einem strahlungsempfindlichen Gemisch gemäß einem der vorhergehenden Ansprüche besteht.

**Patentansprüche für folgende Vertragsstaaten : DE, FR, IT**

**1.** Positiv arbeitendes UV-strahlungsempfindliches Gemisch enthaltend

(a) eine säurelabile Ether-, Ester- oder Carbonatgruppen enthaltendes, in Wasser unlösliches organisches Bindemittel, das durch Einwirkung von Säure in wäßrig-alkalischen Lösungen löslich wird, und

(b) eine organische Verbindung, welche unter Einwirkung von UV-Strahlung eine Säure erzeugt,

dadurch gekennzeichnet, daß es als organische Verbindung (b) enthält Arylsulfonsäureester der allgemeinen Formel (I)

$$Ar - SO_2 - O - R \quad (I),$$

worin

Ar für Phenyl, ein-, zwei- oder dreifach $C_1$-$C_4$-alkyl-, $C_1$-$C_4$-alkoxy- oder halogen-substituiertes Phenyl oder Nitrophenyl,

R für $C_1$-$C_{12}$-Alkyl, Cycloalkyl oder Aralkyl mit bis zu 12 C-Atomen oder durch Alkyl, Alkoxy oder Halogen, einfach oder mehrfach substituiertes Alkyl, Cyclo-alkyl oder Aralkyl mit bis zu 12 C-Atomen stehen,

oder Aryl mit R zusammen einen, ggf. substituierten, fünf- oder sechsgliedrigen Ring bildet, oder daß es als organische Verbindung (b) Di-o-tosyl-2,3-O-isopropyliden-threitol enthält.

**2.** Strahlungsempfindlichen Gemisch nach Anspruch 1, dadurch gekennzeichnet, daß es als organische Verbindungen (b) eine Verbindung ausgewählt aus der Gruppe von Benzolsulfonsäuremethylester, Benzolsulfonsäureethylester, Benzosulfonsäurepropylester, Benzosulfonsäure-2methylbutylester oder Benzolsulfonsäurephenylester enthält.

**3.** Strahlungsempfindliches Gemisch nach Anspruch 1, dadurch gekennzeichnet, daß es als organische Verbindung (b) 3-Halogen-1,2-benzoxathial-1,1-dioxid enthält, worin Hal für Chlor oder Brom steht.

**4.** Strahlungsempfindliches Gemisch gemäß Anspruch 1, dadurch gekennzeichnet, daß es als säurelabile Ether-, Ester- oder Carbonatgruppen im Bindemittel (a) tert. Butylether von Phenolen, tert. Alkyl-carbonate von Phenolen oder tert. Butylester von Carbonsäuren enthält.

**5.** Strahlungsempfindliches Gemisch nach einem der Ansprüche 1 bis 4, dadurch gekennzeichnet, daß es als säurelabile Carbonatgruppen enthaltendes organisches Bindemittel (a) Poly-p-tert.butoxycarbonyloxystyrol oder ein Copolymerisat des p-tert.butoxycarbonyloxystyrols enthält.

**6.** Strahlungsempfindliches Gemisch nach einem der Ansprüche 1 bis 4, dadurch gekennzeichnet, daß es als säurelabile Estergruppen enthaltendes organisches Bindemittel (a) Polytert.butylmethacrylat oder ein Copolymerisat des tert.Butylmethacrylats enthält.

**7.** Verfahren zur Herstellung von Reliefmustern, wobei eine strahlungsempfindliche Aufzeichnungsschicht bildmässig in solcher Dosis mit UV-Licht bestrahlt wird, daß die Löslichkeit der belichteten Bereiche, gegebenenfalls nach einem thermischen Ausheizungsschritt, bei Temperaturen zwischen 60 und 130°C, in wäßrig-alkalischen Lösungen zunimmt und diese Bereiche selektiv mit dem wäßrig-alkalischen Entwickler entfernt werden können, dadurch gekennzeichnet, daß die strahlungsempfindliche Aufzeichnungsschicht im wesentlichen aus einem strahlungsempfindlichen Gemisch gemäß einem der vorhergehenden Ansprüche besteht.

## Claims

### Claims for the following Contracting States : NL, BE

**1.** A positive-working UV-sensitive mixture containing

(a1) a water-insoluble organic binder which contains acid-labile ether, ester or carbonate groups and is soluble in aqueous alkaline solutions as a result of the action of an acid, or
(a2) a polymeric binder which is insoluble in water but soluble in aqueous alkaline solutions and
(a2.1) an organic compound whose solubility in an aqueous alkaline developer is increased by the action of an acid and which contains one or more acid-cleavable groups which form an acid under the action of radiation, or a mixture of the organic compounds (a2.1) and (a2.2), and
(a2.2) an organic compound whose solubility in an aqueous alkaline developer is increased by the action of an acid and which contains one or more acid-cleavable groups and in addition a group which forms an acid under the action of radiation, or a mixture of the organic compounds (a2.1) and (a2.2) and
(b) an organic compound which produces an acid under the action of UV radiation,

which contains an arylsulfonic ester of the formula (I)

$$Ar - SO_2 - O - R \quad (I)$$

where Ar is phenyl or is nitrophenyl or phenyl which is monosubstituted, disubstituted or trisubstituted by $C_1$-$C_4$-alkyl, $C_1$-$C_4$-alkoxy or halogen and R is $C_1$-$C_{12}$-alkyl, cycloalkyl, aryl or aralkyl of not more than 12 carbon atoms or is alkyl, cycloalkyl, aryl or aralkyl of not more than 12 carbon atoms which is monosubstituted or polysubstituted by alkyl, alkoxy or halogen, or aryl together with R forms an unsubstituted or substituted five-membered or six-membered ring, as the organic compound (b), or which contains di-O-tosyl-2,3,0-isopropylidenethreitol as the organic compound (b).

**2.** A radiation-sensitive mixture as claimed in claim 1, which contains a compound selected from the group consisting of methyl benzenesulfonate, ethyl benzenesulfonate, propyl benzenesulfonate or 2-methylbutyl benzenesulfonate as the organic compound (b).

**3.** A radiation-sensitive mixture as claimed in claim 1, which contains 3-halo-1,2-benzoxathial 1,1-dioxide, where Hal is chlorine or bromine, as the organic compound (b).

**4.** A radiation-sensitive mixture as claimed in claim 1, which contains a phenyl ester of benzene- or toluenesulfonic acid as the organic compound (b).

**5.** A radiation-sensitive mixture as claimed in any of claims 1 to 4, which contains tert-butyl ethers of phenols, tert-alkyl carbonates of phenols or tert-butyl esters of carboxylic acids as acid-labile ether, ester or carbonate groups in the binder (a1).

**6.** A radiation-sensitive mixture as claimed in any of claims 1 to 5, which contains poly-p-tert-butoxycarbonyloxystyrene or a copolymer of p-tert-butoxycarbonyloxystyrene as the organic binder (a1) containing acid-labile carbonate groups.

**7.** A radiation-sensitive mixture as claimed in any of claims 1 to 5, which contains poly-tert-butyl methacrylate or a copolymer of tert-butyl methacrylate as the organic binder (a1) containing acid-labile ester groups.

**8.** A radiation-sensitive mixture as claimed in claim 1, wherein the polymeric binder (a2) which is insoluble in water but soluble in aqueous alkaline solutions is poly-p-hydroxystyrene, poly-p-hydroxy-α-methylstyrene, a copolymer of p-hydroxy-α-methylstyrene with tert-butoxycarbonyloxystyrene, tert-amylcarbonyloxystyrene, tert-butoxystyrene, tert-butyl methacrylate, 2-methylhydroxystyrene and/or 2,6-dimethylhydroxystyrene.

**9.** A process for the production of a relief pattern, a radiation-sensitive recording layer being exposed imagewise to UV light in a dose such that the solubility of the exposed parts, if necessary after a thermal heating step, at from 60 to 130°C, in aqueous alkaline solutions increases, and these parts can be removed selectively by means of an aqueous alkaline developer, wherein the radiation-sensitive recording layer essentially consists of a radiation-sensitive mixture as claimed in any of the preceding claims.

**Claims for the following Contracting States : DE, FR, IT**

**1.** A positive-working UV-sensitive mixture containing

(a) a water-insoluble organic binder which contains acid-labile ether, ester or carbonate groups and is soluble in aqueous alkaline solutions as a result of the action of an acid, and
(b) an organic compound which produces an acid under the action of UV radiation,

which contains an arylsulfonic ester of the formula (I)

$$Ar - SO_2 - O - R \quad (I)$$

where Ar is phenyl or is nitrophenyl or phenyl which is monosubstituted, disubstituted or trisubstituted by $C_1$-$C_4$-

alkyl, $C_1$-$C_4$-alkoxy or halogen and R is $C_1$-$C_{12}$-alkyl, cycloalkyl or aralkyl of not more than 12 carbon atoms or is alkyl, cycloalkyl or aralkyl of not more than 12 carbon atoms which is monosubstituted or polysubstituted by alkyl, alkoxy or halogen, or aryl together with R forms an unsubstituted or substituted five-membered or six-membered ring, as the organic compound (b), or which contains di-O-tosyl-2,3,0-isopropylidenethreitol as the organic compound (b).

**2.** A radiation-sensitive mixture as claimed in claim 1, which contains a compound selected from the group consisting of methyl benzenesulfonate, ethyl benzenesulfonate, propyl benzenesulfonate, 2-methylbutyl benzenesulfonate or phenyl benzenesulfonate as the organic compound (b).

**3.** A radiation-sensitive mixture as claimed in claim 1, which contains 3-halo-1,2-benzoxathial 1,1-dioxide, where Hal is chlorine or bromine, as the organic compound (b).

**4.** A radiation-sensitive mixture as claimed in claim 1, which contains tert-butyl ethers of phenols, tert-alkyl carbonates of phenols or tert-butyl esters of carboxylic acids as acid-labile ether, ester or carbonate groups in the binder (a).

**5.** A radiation-sensitive mixture as claimed in any of claims 1 to 4, which contains poly-p-tert-butoxycarbonyloxystyrene or a copolymer of p-tert-butoxycarbonyloxystyrene as the organic binder (a) containing acid-labile carbonate groups.

**6.** A radiation-sensitive mixture as claimed in any of claims 1 to 4, which contains poly-tert-butyl methacrylate or a copolymer of tert-butyl methacrylate as the organic binder (a) containing acid-labile ester groups.

**7.** A process for the production of a relief pattern, a radiation-sensitive recording layer being exposed imagewise to UV light in a dose such that the solubility of the exposed parts, if necessary after a thermal heating step, at from 60 to 130°C, in aqueous alkaline solutions increases, and these parts can be removed selectively by means of an aqueous alkaline developer, wherein the radiation-sensitive recording layer essentially consists of a radiation-sensitive mixture as claimed in any of the preceding claims.

## Revendications

### Revendications pour les Etats contractants suivants : NL, BE

**1.** Mélange sensible aux rayonnements UV, opérant en positif, qui contient

(a1) un liant organique insoluble dans l'eau, contenant des groupes éther, ester ou carbonate instables aux acides, ce liant devenant soluble dans les solutions aqueuses alcalines sous l'action d'un acide, ou bien

(a2) un liant polymère insoluble dans l'eau mais soluble dans les solutions aqueuses alcalines et

(a2.1) un composé organique dont la solubilité dans un révélateur aqueux-alcalin est accrue sous l'action d'un acide et qui contient au moins un groupement scindable par les acides et qui, sous l'action du rayonnement, forme un acide, ou bien un mélange des composés organiques (a2.1) et (a2.2.)

et

(a2.2) un composé organique dont la solubilité dans un révélateur aqueux-alcalin est accrue sous l'action d'un acide et qui contient au moins un groupement scindable par les acides et un groupe qui forme un acide sous l'action du rayonnement, ou un mélange des composés organiques (a2.1) et (a2.2) et

(b) un composé organique qui produit un acide sous l'action du rayonnement UV, caractérisé par le fait qu'il contient en tant que composé organique (b) un ester d'acide arylsulfonique de formule générale I

$$Ar\text{-}SO_2\text{-}O\text{-}R \qquad (I),$$

dans laquelle

Ar représente un groupe phényle, un groupe phényle portant un, deux ou trois substituants alkyle en C1-C4, alcoxy en C1-C4 ou halogéno, ou un groupe nitrophényle,

R représente un groupe alkyle en C1-C12, cycloalkyle, aryle ou aralkyle contenant jusqu'à 12 atomes de carbone ou un groupe alkyle, cycloalkyle, aryle ou aralkyle contenant jusqu'à 12 atomes de carbone et portant un ou plusieurs substituants alkyle, alcoxy ou halogéno,

ou bien le groupe aryle forme avec R un cycle à cinq ou six chaînons éventuellement substitué, ou bien en ce qu'il contient en tant que composé organique (b) le di-O-tosyl-2,3-O-isopropylidène-thréitol.

**2.** Mélange sensible aux rayonnements selon la revendication 1, caractérisé par le fait qu'il contient en tant que composé organique (b) un composé choisi dans le groupe formé par le benzènesulfonate de méthyle, le benzènesulfonate d'éthyle, le benzènesulfonate de propyle ou le benzènesulfonate de 2-méthylbutyle.

**3.** Mélange sensible aux rayonnements selon la revendication 1, caractérisé par le fait qu'il contient en tant que composé organique (b) le 1,1-dioxyde d'un 3-halogéno-1,2-benzoxathial, dont l'halogène consiste en le chlore ou le brome.

**4.** Mélange sensible aux rayonnements selon la revendication 1, caractérisé par le fait qu'il contient en tant que composé organique (b) un ester phénylique de l'acide benzène- ou toluènesulfonique.

**5.** Mélange sensible aux rayonnements selon l'une des revendications 1 à 4, caractérisé par le fait qu'il contient en tant que groupes éther, ester ou carbonate instables aux acides dans le liant (a1), des éthers tert-butyliques de phénols, des tert-alkyl-carbonates de phénols ou des esters tert-butyliques d'acides carboxyliques.

**6.** Mélange sensible aux rayonnements selon l'une des revendications 1 à 5, caractérisé par le fait qu'il contient en tant que liant organique contenant des groupes carbonate instables aux acides (a1) un poly-p-tert-butoxycarbonyloxystyrène ou un copolymère du p-tert-butoxycarbonyloxystyrène.

**7.** Mélange sensible aux rayonnements selon l'une des revendications 1 à 5, caractérisé par le fait qu'il contient en tant que liant organique à groupes ester instables aux acides (a1) un polyméthacrylate de tert-butyle ou un copolymère du méthacrylate de tert-butyle.

**8.** Mélange sensible aux rayonnements selon la revendication 1, caractérisé par le fait qu'il contient en tant que liant polymère insoluble dans l'eau mais soluble dans les solutions aqueuses alcalines (a2) un poly-p-hydroxystyrène, un poly-p-hydroxy-alpha-méthylstyrène, un copolymère du p-hydroxy-alpha-méthylstyrène et du tert-butoxycarbonyloxystyrène, du tert-amylcarbonyloxystyrène, du tert-butoxystyrène, du méthacrylate de tert-butyle, du 2-méthylhydroxystyrène et/ou du 2,6-diméthylhydroxystyrène.

**9.** Procédé pour former des modèles en relief dans lequel on irradie une couche d'enregistrement sensible aux rayonnements avec formation d'une image par la lumière UV à une dose telle que la solubilité des régions exposées dans les solutions aqueuses alcalines augmente, éventuellement après un chauffage final à des températures de 60 à 130°C, et que ces régions puissent être éliminées sélectivement par le révélateur aqueux-alcalin, caractérisé par le fait que la couche d'enregistrement sensible aux rayonnements consiste essentiellement en un mélange sensible aux rayonnements selon l'une des revendications qui précèdent.

**Revendications pour les Etats contractants suivants : DE, FR, IT**

**1.** Mélange sensible aux rayonnements UV, opérant en positif, qui contient

(a) un liant organique contenant des groupes éther, ester ou carbonate instables aux acides, qui est insoluble dans l'eau mais devient soluble en solution aqueuse-alcaline sous l'action d'un acide, et

(b) un composé organique qui produit un acide sous l'action d'un rayonnement UV,

caractérisé par le fait qu'il contient en tant que composé organique (b) un ester d'acide arylsulfonique de formule générale I

$$Ar - SO_2 - O - R \quad (I),$$

dans laquelle

Ar représente un groupe phényle, un groupe phényle portant un, deux ou trois substituants alkyle en C1-C4, alcoxy en C1-C4 ou halogéno, ou un groupe nitrophényle,

R représente un groupe alkyle en C1-C12, cycloalkyle ou aralkyle contenant jusqu'à douze atomes de carbone, ou un groupe alkyle, cycloalkyle ou aralkyle contenant jusqu'à douze atomes de carbone et qui porte un ou plusieurs substituants alkyle, alcoxy ou halogéno,

ou bien le groupe aryle forme avec le groupe R un cycle à cinq ou six chaînons éventuellement substitué, ou bien en ce qu'il contient en tant que composé organique (b) le di-o-tosyl-2,3-O-isopropylidène-thréitol.

**2.** Mélange sensible aux rayonnements selon la revendication 1, caractérisé par le fait qu'il contient en tant que composé organique (b) un composé choisi dans le groupe constitué par le benzènesulfonate de méthyle, le benzènesulfonate d'éthyle, le benzènesulfonate de propyle, le benzènesulfonate de 2-méthylbutyle ou le benzènesulfonate de phényle.

**3.** Mélange sensible aux rayonnements selon la revendication 1, caractérisé par le fait qu'il contient en tant que composé organique (b) le 1,1-dioxyde d'un 3-halogéno-1,2-benzoxathial, l'halogène consistant en le chlore ou le brome.

**4.** Mélange sensible aux rayonnements selon la revendication 1, caractérisé par le fait qu'il contient en tant que groupes éther, ester ou carbonate instables aux acides dans le liant (a) des éthers tert-butyliques de phénols, des tert-alkyl-carbonates de phénols ou des esters tert-butyliques d'acides carboxyliques.

**5.** Mélange sensible aux rayonnements selon l'une des revendications 1 à 4, caractérisé par le fait qu'il contient en tant que liant organique contenant des groupes carbonate instables aux acides (a) un poly-p-tert-butoxycarbonyloxystytrène ou un copolymère du p-tert-butoxycarbonyloxystyrène.

**6.** Mélange sensible aux rayonnements selon l'une des revendications 1 à 4, caractérisé par le fait qu'il contient en tant que liant organique contenant des groupes ester instables aux acides (a) un polyméthacrylate de tert-butyle ou un copolymère du méthacrylate de tert-butyle.

**7.** Procédé pour former des modèles en relief dans lequel on irradie une couche d'enregistrement sensible aux rayonnements avec formation d'une image par la lumière UV à une dose telle que la solubilité des régions exposées dans les solutions aqueuses alcalines augmente, le cas échéant après une opération de chauffage finale à des températures de 60 à 130°C, et que ces régions puissent être éliminées sélectivement par le révélateur aqueux-alcalin, caractérisé par le fait que la couche d'enregistrement sensible aux rayonnements consiste essentiellement en un mélange sensible aux rayonnements selon l'une des revendications qui précèdent.